# EUROPÄISCHE PATENTSCHRIFT

(11) **EP 3 172 752 B1**
(45) Veröffentlichungstag und Bekanntmachung des Hinweises auf die Patenterteilung: **25.04.2018**
(21) Anmeldenummer: 15736452.2
(22) Anmeldetag: 08.07.2015
(51) Int. Cl.: H01H 23/30, B60K 37/06, H03K 17/96, H03K 17/965

(54) **BEDIENEINHEIT FÜR EIN ELEKTRISCHES GERÄT, INSBESONDERE FÜR EINE FAHRZEUGKOMPONENTE**
CONTROL UNIT FOR AN ELECTRICAL APPARATUS, IN PARTICULAR FOR A VEHICLE COMPONENT
UNITÉ DE COMMANDE POUR APPAREIL ÉLECTRIQUE, EN PARTICULIER POUR COMPOSANT DE VÉHICULE

(30) Priorität: 22.07.2014 DE 102014214218
(43) Veröffentlichungstag der Anmeldung: 31.05.2017
(73) Patentinhaber: Behr-Hella Thermocontrol GmbH, 70469 Stuttgart (DE)
(72) Erfinder: BESCHNITT, Alexander, 59557 Lippstadt (DE); FUST, Winfried, 59557 Lippstadt (DE); STEINKAMP, Michael, 59557 Lippstadt (DE); VOGT, Frank, 59557 Lippstadt (DE); FISCHER, Christof, 59557 Lippstadt (DE); BÖHM, Nils, 59557 Lippstadt (DE)
(74) Vertreter: dompatent von Kreisler Selting Werner - Partnerschaft von Patent- und Rechtsanwälten mbB
(86) Internationale Anmeldenummer: PCT/EP2015/065587
(87) Internationale Veröffentlichungsnummer: WO 2016/012243

(56) Entgegenhaltungen:
- EP-A1- 1 988 441
- WO-A1-00/34068
- WO-A1-2013/153048
- DE-A1-102011 010 229
- DE-B3-102012 221 107

## Beschreibung

Bedieneinheiten für elektrische Geräte sind in den unterschiedlichsten Ausgestaltungen bekannt. Insbesondere im Kfz-Bereich haben sich in jüngster Vergangenheit Bedienkonzepte durchgesetzt, bei denen ein leistenförmiges Bedienelement mit mehreren Bedienfeldern zur Auslösung unterschiedlicher Gerätefunktionen bei manueller Betätigung bewegbar gelagert ist, wobei eine entsprechende Sensorik die Anlageposition des Fingers einer Hand auf der Bedienleiste erkennt und damit ermittelbar ist, welche Gerätefunktion ausgewählt worden ist. Bei der Sensorik handelt es sich beispielsweise um Näherungs- bzw. Berührungssensoren, die zumeist kapazitiv arbeiten. Wenn z.B. aus Design-Gründen die gesamte Bedienleiste eine metallische Bedienfläche aufweist oder die Betätigung beim Tragen von Handschuhen erfolgen kann, so lässt sich eine kapazitive Sensorik in der Bedienleiste nicht verwenden. Es existieren andere Konzepte, bei denen durch Biegekraft- oder Abstandssensoriken an verschiedenen Stellen der Aufhängung der Bedienleiste anhand von Differenzsignalen ermittelt werden kann, an welcher Position sich der Finger einer Hand bei Betätigung der Bedienleiste befindet (siehe z.B. WO-A-2013/153048).

Aus der WO-A-2013/153048 ist eine Bedieneinheit für ein elektrisches Gerät mit einem Gehäuse, das eine Vorderwand aufweist, einer über die Vorderwand vorstehenden Bedienleiste, die eine langgestreckte Bedienfläche mit einer Vielzahl von nebeneinander angeordneten Bedienfeldern aufweist, einem in dem Gehäuse angeordneten Trägerelement für die Bedienleiste, einer Auswerte- und Ansteuereinheit zum Empfangen der Signale der Bedienfeld-Betätigungssensoren sowie zur anhand dieser Signale erfolgenden Ermittlung desjenigen Bedienfeldes, auf dem bei manueller Betätigung der Bedienleiste der Finger einer Hand anliegt, und zum Auslösen einer dem betreffenden Bedienfeld zugeordneten Gerätefunktion entsprechend dem ermittelten Bedienfeld bekannt.

Aus DE-B-10 2012 221 107 ist eine Bedieneinheit für eine Fahrzeugkomponente mit einem Gehäuse mit Vorderwand und über die Vorderwand vorstehender Bedienleiste mit einer Vielzahl von Bedienfeldern, sowie einem in dem Gehäuse angeordneten Trägerelement und einer Auswerte- und Ansteuereinheit bekannt.

Aus US-A-2008/0018611 ist eine Bedieneinheit für ein elektrisches Gerät mit einer Vorderwand und einer Bedienleiste mit einer Vielzahl von Bedienfeldern, einem Trägerelement und einer Auswerte- und Ansteuereinheit bekannt, wobei die Bedienleiste über Verbindungsstege zwischen den Bedienfeldern mit dem Trägerelement verbunden ist und die Bedienfelder der Bedienleiste elastisch sowie flexibel zwischen den Verbindungsstegen angeordnet sind und am Trägerelement mindestens ein Bedienfeld-Betätigungssensor zur Erfassung einer lokalen Durchbiegung der Bedienleiste bei manueller Betätigungsausübung angeordnet ist.

Aufgabe der Erfindung ist es, eine Bedieneinheit für ein elektrisches Gerät zu schaffen, bei dem sich die Position des Fingers bei Betätigung einer Bedienleiste der Bedieneinheit mit großer Zuverlässigkeit und sicher detektieren lässt.

Zur Lösung dieser Aufgabe wird mit der Erfindung eine Bedieneinheit für ein elektrisches Gerät, insbesondere für eine Fahrzeugkomponente wie z.B. eine Heizungs-, Lüftungs- und/oder Klimaanlage vorgeschlagen, wobei die Bedieneinheit versehen ist mit den Merkmalen des Anspruchs 1. Einzelne Ausgestaltungen der Erfindung sind Gegenstand der Unteransprüche.

Die erfindungsgemäße Bedieneinheit weist ein Gehäuse mit einer Vorderwand auf, über die eine Bedienleiste übersteht, die eine entlang der Vorderwand verlaufende, langgestreckte Bedienfläche mit einer Vielzahl von nebeneinander angeordneten Bedienfeldern aufweist. In dem Gehäuse ist ein Trägerelement angeordnet, mit dem die Bedienleiste in ihren Bereichen zwischen den Bedienfeldern vergleichsweise starr und im Bereich ihrer Bedienfelder vergleichsweise flexibel verbunden ist. Zu diesem Zweck stehen von dem Trägerelement wechselweise Verbindungsstege und Biegestege ab. Die Verbindungsstege sind vergleichsweise starr und mit der Bedienleiste in deren jeweiligen Bereichen zwischen den Bedienfeldern verbunden. Die Biegestege befinden sich jeweils zwischen zwei benachbarten Verbindungsstegen und dienen zur flexiblen, elastischen Anbindung der Bedienleiste an das Trägerelement im Bereich der Bedienfelder der Bedienleiste.

Die Bedienleiste ist aus einem Material gefertigt (im Regelfall Kunststoff), so dass sie sich bei einer manuellen Betätigung, d.h. beim Andrücken mit dem Finger einer Hand lokal elastisch verbiegt, was aber optisch nicht zu erkennen ist. Wenn also der Finger einer Hand an einem Bedienfeld der Bedienleiste anliegt und dann gegen die Bedienleiste drückt, so biegt sich die Bedienleiste innerhalb dieses Bedienfeldes leicht und für den Bediener unmerklich durch, wobei dies durch die vergleichsweise starre Anbindung der Bedienleiste zwischen benachbarten Bedienfeldern im Wesentlichen auf das betreffende Bedienfeld beschränkt ist, die Bedienfelder also insoweit mechanisch entkoppelt sind. Jedem Bedienfeld der Bedienleiste ist erfindungsgemäß ein Bedienfeld-Betätigungssensor zugeordnet, der am Trägerelement positioniert ist. Jeder Bedienfeld-Betätigungssensor erfasst die lokale Durchbiegung der Bedienleiste bei manueller Betätigungskraftausübung auf ein Bedienfeld der Bedienleiste, indem sich der Biegesteg, der mit dem entsprechenden Bedienfeld der Bedienleiste verbunden ist, verbiegt. Über eine Auswerte- und Ansteuereinheit, die mit den Bedienfeld-Betätigungssensoren verbunden ist, kann nun anhand der Signale dieser Bedienfeld-Betätigungssensoren dasjenige Bedienfeld ermittelt werden, auf dem bei manueller Betätigung der Bedienleiste der Finger einer Hand anliegt. Dementsprechend kann dann die dem betreffenden Bedienfeld zugeordnete Gerätefunktion ausgelöst werden. Durch die mechanische Durchbiegungsentkopplung der Bedienleiste gibt also der Bedienfeld-Betätigungssensor, der demjenigen Bedienfeld zugeordnet ist, auf dem bei Betätigung der Finger einer Hand anliegt, das größte Signal im Vergleich zu den Bedienfeld-Betätigungssensoren aus, die dem betreffenden Bedienfeld benachbart angeordnet sind.

Durch diese Art von Signalmustererkennung kann dann sehr zuverlässig auf das Bedienfeld geschlossen werden, an dem der Finger einer Hand bei Betätigung der Bedienleiste anliegt. Sollten beispielsweise die Bedienfeld-Betätigungssensoren zweier benachbarter Bedienfelder im Wesentlichen gleich große Signale ausgeben, so ist dies ein Indiz dafür, dass der Finger der Hand bei Betätigung der Bedienleiste auf der Grenze zwischen zwei Bedienfeldern anliegt; in diesem Fall sollte keine Gerätefunktion ausgelöst werden.

Mit dem erfindungsgemäßen Konzept lässt sich sehr genau bei Betätigung einer langgestreckten Bedienleiste ermitteln, wo sich der Finger einer Hand auf der Bedienleiste befindet, wenn diese betätigt wird.

Die wechselweise unterschiedlich flexible Anbindung der Bedienleiste an das Trägerelement kann in vielfacher unterschiedlicher Weise ausgeführt sein. So ist es beispielsweise denkbar, dass die Verbindungsstege aufgrund ihrer Geometrie, ihres Materials und/oder der Position ihrer Anbindung an das Trägerelement und/oder die Bedienleiste steifer ausgebildet sind als die Biegestege und/oder dass bei gleicher Geometrie und gleichem Material der Verbindungssowie der Biegestege die Verbindungsstege an einer ersten Anbindungsstelle von dem Trägerelement und die Biegestege an einer zweiten Anbindungsstelle von dem Trägerelement abstehen, wobei die zweite Anbindungsstelle von den Biegestegen weiter beabstandet sind als die erste Anbindungsstelle.

In weiterer zweckmäßiger Ausgestaltung der Erfindung kann vorgesehen sein, dass das Trägerelement seinerseits schwenkbar zwischen einer Ruheposition, in die das Trägerelement vorgespannt ist, und mindestens einer Schwenkposition gelagert ist und dass mit der Auswerte- und Ansteuereinheit mindestens ein Schwenkpositionssensor zur Erfassung der Einnahme einer Schwenkposition des Trägerelements bei einer Betätigung der Bedienleiste verbunden ist. Bei dieser Ausgestaltung der Erfindung ist also die Bedienleiste geringfügig schwenkbar, indem das Trägerelement im Gehäuse geringfügig schwenkbar gelagert ist. Dabei kann das Trägerelement aus einer Mittelposition heraus in zwei entgegengesetzte Richtungen schwenkbar oder aber aus einer Ruheposition heraus in lediglich eine Schwenkrichtung schwenkbar sein. In beiden Fällen sollte das Trägerelement in die Mitten- bzw. Ruheposition vorgespannt sein, so dass das Trägerelement diese Position nach Beendigung der Betätigung der Bedienleiste automatisch wieder einnimmt. Über mindestens einen Schwenkpositionssensor ist die Einnahme der mindestens einen Schwenkposition des Trägerelements erfassbar. Der Schwenkpositionssensor ist mit der Auswerte- und Ansteuereinheit verbunden, in der damit anhand des Signals des bzw. der Schwenkpositionssensoren erkannt wird, ob eine Betätigung der Bedienleiste stattgefunden hat. Über die Bedienfeld-Betätigungssensoren kann dann anschließend, wie oben beschrieben die Fingerposition auf der Bedienleiste detektiert werden.

In weiterer zweckmäßiger Ausgestaltung kann ferner vorgesehen sein, dass die Verbindungsstege und die Biegestege von einem gemeinsamen Quersteg abstehen und dass das Trägerelement einen Trägerkörper mit wechselweise nebeneinander angeordneten Randaussparungen und diese voneinander trennenden Vorsprungsbereichen, die einen zur Bedienleiste weisenden Bedienleisten-Randabschnitt des Trägerkörpers bilden, aufweist, wobei die Biegestege in den Randaussparungen verlaufen sowie über den Bedienleisten-Randabschnitt überstehen und die Biegestege in den Vorsprungsbereichen des Trägerkörpers an diesem fixiert sind sowie ebenfalls über den Bedienleisten-Randabschnitt überstehen. Die im Wesentlichen kammartige Struktur des Trägerkörpers des Trägerelements gewährleistet es, dass die in den Randaussparungen verlaufenden, über den Bedienleisten-Randabschnitt überstehenden Biegestege wegen der größeren freien Biegelänge flexibler sind als die vergleichsweise kurzen Biegestege, die an den Vorsprungsbereichen des Trägerkörpers fixiert sind und demzufolge für einen vergleichsweise kurzen Abschnitt über den Bedienleisten-Randabschnitt des Trägerkörpers überstehen.

In konstruktiver und montagetechnischer Hinsicht von Vorteil kann es sein, wenn der Quersteg, die Verbindungsstege und die Biegestege ein einstückiges, kammartiges, insbesondere Metall aufweisendes Verbindungselement des Trägerelements mit der Bedienleiste bilden, wobei das Trägerelement das Verbindungselement umspritzten Kunststoff aufweisen kann.

Bei der zuvor beschriebenen vorteilhaften Ausgestaltung der Erfindung kann der Trägerkörper vorteilhafterweise mit einer Betätigungssensor-Trägerplatte verbunden sein, die die Randaussparungen des Trägerkörpers überdeckt und in diesen Überdeckungsbereichen den Biegestegen zugeordnete Bedienfeld-Betätigungssensoren aufweist. Die Betätigungssensor-Trägerplatte, die die Bedienfeld-Betätigungssensoren aufweist, liegt also an dem Trägerkörper bspw. an dessen Oberseite oder Unterseite an. Die Bedienfeld-Betätigungssensoren sind in den Überdeckungsbereichen angeordnet und detektieren eine Verbiegung der Biegestege. Zweckmäßig kann es sein, wenn der Trägerkörper beidseitig mit jeweils einer Betätigungssensorplatte verbunden ist. Somit kann dann bspw. durch Differenzmessung zweier jeweils einem Biegesteg zugeordneter Bedienfeld-Betätigungssensoren eine Verbiegung des betreffenden Biegesteges zuverlässig erkannt werden, wobei darüber hinaus auch noch die Biegerichtung erkennbar ist. Dies ist von Vorteil, wenn die Bedienleiste in zwei entgegengesetzten Richtungen bedienbar ist, z.B. durch Auflegen eines Fingers auf die Oberseite der Bedienleiste und Drücken der Bedienleiste nach unten und durch Anlage des Fingers einer Hand an der Unterseite der Bedienleiste und Hochdrücken der Bedienleiste.

Die beiden unterschiedlichen Betätigungsrichtungen der Bedienleiste sind auch unter Verwendung jeweils lediglich eines Bedienfeld-Betätigungssensors möglich, wenn der Biegesteg gegen den Sensor vorgespannt ist und sich je nach Betätigungsrichtung die auf den Sensor wirkende Spannung erhöht oder verringert.

Für die Bedienfeld-Betätigungssensoren und, sofern vorhanden, den oder die Schwenkpositionssensoren gilt, dass diesbezüglich kapazitiv, induktiv, ohmsch oder optisch arbeitende (Weg- oder Kraft- bzw. Druck-)Sensoriken eingesetzt werden können. Schließlich ist es auch möglich, Endschalter zu verwenden.

Aus designerischen Gründen kann es von Vorteil sein, wenn die Bedienleiste zumindest auf ihrem Bedienfeld mit einer beschichteten und somit veredelten Oberfläche versehen ist. Dies kann eine lackierte Oberfläche oder in einer weiteren beispielhaften Ausführungsform eine metallische Oberfläche sein. Diesen Designfreiheitsgrad ermöglicht das erfindungsgemäße Konzept, da die Detektion des Fingerauflagepunktes auf der Bedienleiste nicht in der Bedienleiste selbst, sondern außerhalb der Bedienleiste, nämlich im Trägerelement erfolgt. Auch eine Betätigung der Bedienleiste durch eine Handschuh-Bedienung ist erfindungsgemäß möglich.

Das erfindungsgemäße Konzept kann mit Force Sense/Force Feedback-Bediensystemen kombiniert werden. Diesbezüglich kann vorgesehen sein, dann, wenn eine Betätigung der Bedienleiste detektiert wird, diese in erzwungene mechanische Bewegungen zu versetzen, um auf diese Weise der Bedienperson eine haptische/taktile Betätigungsrückmeldung zu geben.

Die Erfindung wird nachfolgend anhand eines Ausführungsbeispiels sowie unter Bezugnahme auf die Zeichnung näher erläutert. Im Einzelnen zeigen dabei:
- Fig. 1: eine Vorderansicht einer Bedieneinheit für ein elektrisches Gerät in perspektivischer Darstellung,
- Fig. 2: eine perspektivische Ansicht auf die "aufgeschnittene" Bedieneinheit gemäß Fig. 1 zur Verdeutlichung der Schwenklagerung und Anbindung der Bedienleiste an ein im Gehäuse schwenkbar gelagertes Trägerelement,
- Fig. 3: eine Draufsicht auf das aufgeschnittene Gehäuse gemäß dem Pfeil III der Fig. 2,
- Fign. 4 und 5: perspektivische Schnittansichten des Trägerelements entlang der Linien IV und V der Fig. 3 bei wiederum aufgeschnittenem Gehäuse zur Verdeutlichung des Aufbaus des Trägerelements und dessen Anbindung an die Bedienleiste,
- Fig. 6: einen Schnitt durch das Gehäuse gemäß VI der Fig. 1 zur Verdeutlichung des Zusammenwirkens zweier Bedienfeld-Betätigungssensoren pro Biegesteg mit diesem und
- Fig. 7: eine perspektivische Vorderansicht wie in Fig. 1, jedoch mit Verdeutlichung der Durchbiegung im Bereich des Bedienfeldes 2, auf dem sich in diesem Ausführungsbeispiel der Finger der Hand bei Betätigung der Bedienleiste befindet.

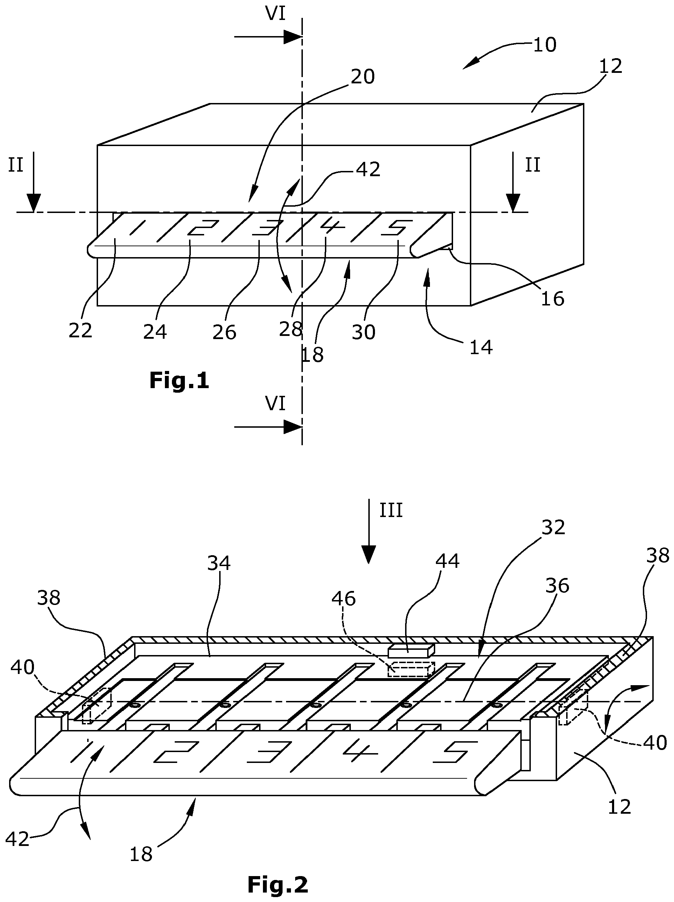

In Fig. 1 ist perspektivisch und als Vorderansicht eine vereinfachte Bedieneinheit 10 gezeigt. Die Bedieneinheit 10 weist ein Gehäuse 12 mit einer Vorderwand 14 auf, in der sich eine Aussparung 16 befindet. Durch die Aussparung 16 hindurch ragt eine Bedienleiste 18, die über die Vorderwand 14 übersteht. Die Bedienleiste 18 weist eine Bedienfläche 20 mit mehreren, nebeneinander angeordneten Bedienfeldern 22,24,26,28 und 30 auf. Die Bedieneinheit 10 weist im Regelfall noch andere Bedienelemente und insbesondere auch Anzeigeelemente in Form von Displays oder anderen optischen Anzeigeelementen auf, auf die es im Rahmen der Erfindung aber nicht ankommt, weshalb diese hier nicht näher beschrieben werden und in den Figuren nicht gezeigt sind.

Wie insbesondere anhand der Fign. 2 bis 6 zu erkennen ist, ist die Bedienleiste 18 mit einem Trägerelement 32 verbunden, das innerhalb des Gehäuses 12 angeordnet ist. Das Trägerelement 32 ist im Wesentlichen plattenförmig ausgebildet und weist einen Trägerkörper 34 auf, der um eine Schwenkachse 36 schwenkbar im Gehäuse 12 gelagert ist. Zu diesem Zweck weist das Gehäuse 12 beispielsweise im Bereich seiner beiden Seitenwände 38 zwei Schwenklagerböcke 40 auf, auf denen der Trägerkörper 34 schwenkbar aufliegt. Damit lässt sich die Bedienleiste 18 in eine der beiden durch den Doppelpfeil 42 angedeuteten Verschwenkrichtungen verschwenken. Über zwei Schwenkpositionssensoren 44,46, die bspw. als Endschalter ausgebildet sind, lässt sich eine Verschwenkung des Trägerelements 32 in beiden Richtungen erfassen.

Von Bedeutung für das hier beschriebene Ausführungsbeispiel ist die örtlich wechselweise unterschiedliche, flexible Anbindung der Bedienleiste 18 an das Trägerelement 32. Dies wird nachfolgend anhand der Fign. 2 bis 5 beschrieben.

Die mechanische Verbindung der Bedienleiste 18 mit dem Trägerelement 32 ist durch eine Vielzahl von nebeneinanderliegenden Stegen aus bspw. Metall oder einem anderen elastisch biegbaren Material realisiert. Dabei wechseln sich Verbindungsstege 48 und Biegestege 50 ab. Diese Stege sind in unterschiedlichen Bereichen der Bedienleiste 18 mit dieser verbunden. So befinden sich die Verbindungsstege 48 in Höhe der Grenzen 52 zwischen jeweils benachbarten Bedienfeldern sowie an den äußersten beiden Enden 54 der Bedienleiste 18, während die Biegestege 50 etwa in der Mitte jedes Bedienfeldes mit der Bedienleiste 18 verbunden sind. Die Verbindungsstege 48 sowie die Biegestege 50 sind blattfederartig ausgebildet und stehen von einem einstückig mit diesen Stegen verbundenen Quersteg 56 ab. Auf diese Weise entsteht ein kammartiges Verbindungselement 59, das Teil des Trägerelements 32 ist.

Das kammartige Verbindungselement 59 ist an dem Trägerkörper 34 fixiert, der in diesem Ausführungsbeispiel Kunststoff aufweist, der um die kammartige Struktur der Stege gespritzt ist. Alternativ kann das kammartige Verbindungselement 59 in einem weiteren Ausführungsbeispiel auch auf dem Trägerkörper 34 montiert sein (z.B. geschraubt, warmgepresst, genietet, etc.). Hierbei weist der Trägerkörper 34 seinerseits ebenfalls eine kammartige Struktur auf, indem er an dem Bedienleisten-Randabschnitt 58, also an demjenigen Randabschnitt des Trägerelements 32, welcher der Bedienleiste 18 zugewandt ist, Randaussparungen 60 mit zwischen diesen befindlichen Vorsprungsbereichen 62 aufweist. Der Quersteg 56, von dem die Biegestege 50 und die Verbindungsstege 48 abstehen, ist am Trägerkörper 34 fixiert, und zwar durch Einbettung in das Kunststoffmaterial des Trägerkörpers 34. Auch die Verbindungsstege 48 sind in das Material des Trägerkörpers 34 eingebettet und somit am Trägerkörper 34 fixiert, indem sie längs der Vorsprungsbereiche 62 verlaufen, und damit lediglich für eine kurze freie Länge 64 über den Bedienleisten-Randabschnitt 58 überstehen.

Demgegenüber verlaufen die Biegestege 50 durch die Randaussparungen 60 hindurch, weisen also eine im Vergleich zu den Verbindungsstegen 48 wesentlich längere freie Biegelänge 66 auf.

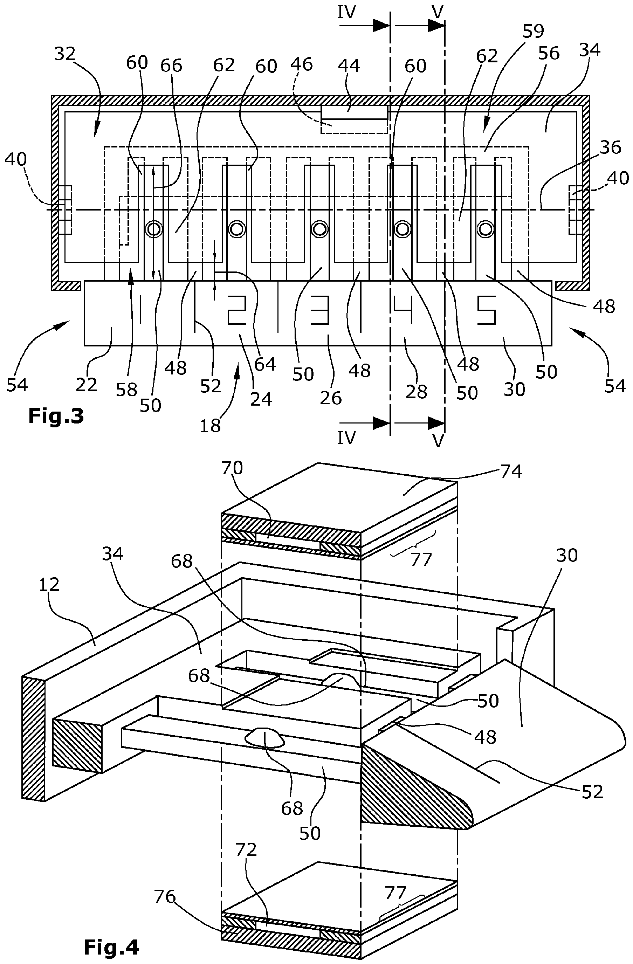

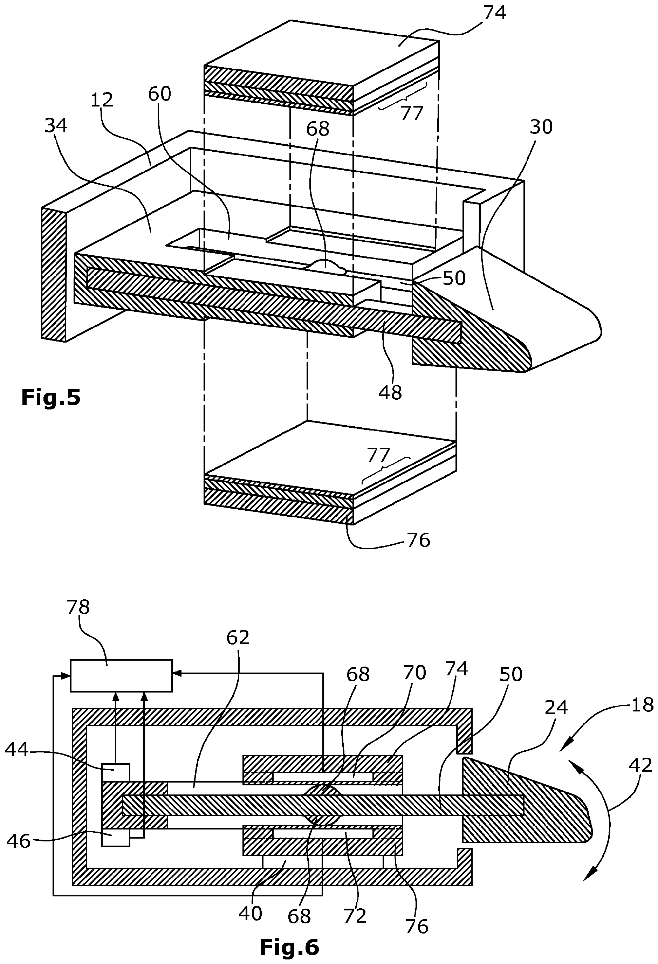

Dies ist nochmals in Fig. 4 verdeutlicht, wobei dort auch zu erkennen ist, dass auf der Ober- und der Unterseite der Biegestege 50 Stößel 68 angespritzt sind, die, wie in Fig. 6 gezeigt, mit Bedienfeld-Betätigungssensoren 70,72 zusammenwirken. Weitere Ausführungsformen können auch geprägte Stößel (im Biegesteg) oder separat montierte Stößel sein. Diese Bedienfeld-Betätigungssensoren 70,72 befinden sich an Trägerplatten 74,76, die ober- und unterhalb des Trägerkörpers 34 auf diesem aufliegen. Die Bedienfeld-Betätigungssensoren 70,72 befinden sich innerhalb von Überbrückungsbereichen 77 der Trägerplatten 74,76, innerhalb derer diese Überbrückungsbereiche 77 die Randaussparungen 60 des Trägerköpers 34 überdecken. Die Bedienfeld-Betätigungssensoren 70,72 und die Schwenkpositionssensoren 44,46 sind mit einer Auswerte- und Ansteuereinheit 78 verbunden, in der ein Niederdrücken oder Hochziehen der Bedienleiste 18 erkannt wird, und zwar anhand der Signale der Schwenkpositionssensoren 44,46, und in der darüber hinaus auch erkannt wird, an welchem Bedienfeld der Bedienleiste 18 der Finger einer Hand bei Betätigung der Bedienleiste anliegt bzw. angreift.

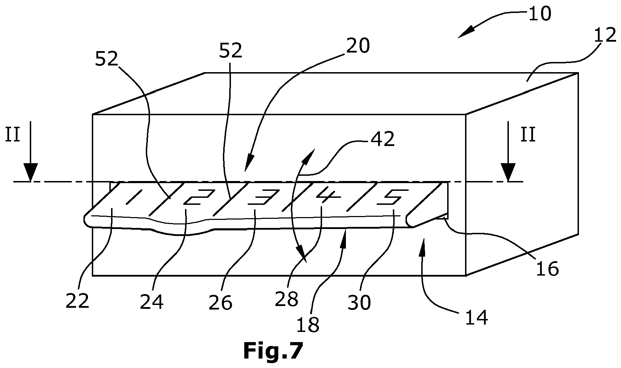

Letzteres wird anhand der lokalen Durchbiegung der Bedienleiste 18 erkannt, was in Fig. 7 verdeutlicht ist. Bei Auflage des Fingers einer Hand auf z.B. dem Bedienfeld 24 bei der Betätigung der Bedienleiste 18 biegt sich diese im Bereich des Bedienfeldes 24 in diesem Beispiel nach unten durch. An den Grenzen 52 des Bedienfeldes 24 zu seinen Nachbar-Bedienfeldern 22,26 ist die Bedienleiste 18 vergleichsweise starr an den Trägerkörper 34 angebunden. Die Durchbiegung im Bereich des Bedienfeldes 24 wird also stark gedämpft an die Nachbar-Bedienfelder 22,26 übertragen. Die Durchbiegung im Bereich des Bedienfeldes 24 wird anhand einer Auslenkung des diesem Bedienfeld 24 zugeordneten Biegesteges 50 erkannt, und zwar über die Bedienfeld-Betätigungssensoren 70,72 dieses besagten Biegesteges 50. Die Bedienfeld-Betätigungssensoren 70,72, die dem Bedienfeld 24 zugeordnet sind, geben ein größeres Signal ab als die Bedienfeld-Betätigungssensoren 70,72, die den Nachbar-Bedienfeldern 22,26 bzw. den Biegestegen 50 dieser Nachbar-Bedienfelder zugeordnet sind.

Durch das hier beschriebene Konzept einer lokal flexibel sowie lokal starr und diesbezüglich wechselseitig flexibel und starr gekoppelten Bedienleiste lässt sich also mit großer Sicherheit und Zuverlässigkeit der Angriffspunkt bei manueller Betätigung der Bedienleiste 18 ermitteln. Hierzu bedarf es keinerlei Touch-Sensorik oder kapazitiver Sensorik der Bedienleiste 18 selbst, so dass diese hinsichtlich der Oberflächengestaltung und des Oberflächenmaterials große Freiheitsgrade aufweist, die insbesondere nicht durch Sensoriken zur Berührungserkennung beeinträchtigt sind. So kann beispielsweise die Bedienfläche 20 oder aber auch die gesamte Oberfläche der Bedienleiste 18 beschichtet und somit veredelt sein, wobei der Verbund aus Trägermaterial der Bedienleiste 18 und Oberflächenschicht ausreichend elastisch flexibel ist, um lokale, elastische Verbiegungen der Bedienleiste 18 zu detektieren, jedoch für den Benutzer unmerklich, um so den Eindruck einer starren Bedienleiste zu vermitteln.

### BEZUGSZEICHENLISTE

10 Bedieneinheit
12 Gehäuse der Bedieneinheit
14 Vorderwand des Gehäuses
16 Aussparung in der Vorderwand
18 Bedienleiste
20 Bedienfläche der Bedienleiste
22 Bedienfeld auf der Bedienfläche
24 Bedienfeld auf der Bedienfläche
26 Bedienfeld auf der Bedienfläche
28 Bedienfeld auf der Bedienfläche
30 Bedienfeld auf der Bedienfläche
32 Trägerelement für die Bedienleiste
34 Trägerkörper des Trägerelements
36 Schwenkachse des Trägerelements
38 Seitenwände des Gehäuses
40 Schwenklagerböcke
42 Doppelpfeil (Schwenkrichtungen der Bedienleiste)
44 Schwenkpositionssensor
46 Schwenkpositionssensor
48 Verbindungsstege
50 Biegestege
52 Grenzen zwischen den Bedienfeldern
54 Enden der Bedienleiste
56 Quersteg
58 Bedienleisten-Randabschnitt
59 kammartiges Verbindungselement zwischen Trägerkörper und Bedienleiste
60 Randaussparungen
62 Vorsprungsbereiche
64 freie Länge jedes Verbindungsstegs
66 Biegelänge jedes Biegestegs
68 Stößel
70 Bedienfeld-Betätigungssensor
72 Bedienfeld-Betätigungssensor
74 Sensorträgerplatte
76 Sensorträgerplatte
77 Überbrückungsbereiche jeder Sensorträgerplatte
78 Auswerte- und Ansteuereinheit

## Patentansprüche

1. Bedieneinheit für ein elektrisches Gerät mit
- einem Gehäuse (12), das eine Vorderwand (14) aufweist,
- einer über die Vorderwand (14) vorstehenden Bedienleiste (18), die eine langgestreckte Bedienfläche (20) mit einer Vielzahl von nebeneinander angeordneten Bedienfeldern (22,24,26,28,30) aufweist,
- einem in dem Gehäuse (12) angeordneten Trägerelement (32) für die Bedienleiste (18),
- wobei die Bedienleiste (18) über Verbindungsstege (48), die in den jeweiligen Bereichen zwischen den Bedienfelder (22,24,26,28,30) von der Bedienleiste (18) abstehen, mit dem Trägerelement (32) verbunden ist,
- zwischen den Verbindungsstegen (48) angeordneten, von der Bedienleiste (18) pro Bedienfeld abstehenden Biegestegen (50), die mit dem Trägerelement (32) verbunden sind, und zwar elastisch sowie flexibler als die Verbindungen der Bedienleiste (18) mit dem Trägerelement (32) über die Verbindungsstege (48),
- wobei am Trägerelement (32) pro Biegesteg (50) mindestens ein Bedienfeld-Betätigungssensor (70, 72) zur Erfassung einer lokalen Durchbiegung der Bedienleiste (18) bei manueller Betätigungskraftausübung auf ein Bedienfeld (22,24,26,28,30) der Bedienleiste (18) angeordnet ist, und
- einer Auswerte- und Ansteuereinheit (78) zum Empfangen der Signale der Bedienfeld-Betätigungssensoren (70,72) sowie zur anhand dieser Signale erfolgenden Ermittlung desjenigen Bedienfeldes (22,24,26,28,30), auf dem bei manueller Betätigung der Bedienleiste (18) der Finger einer Hand anliegt, und zum Auslösen einer dem betreffenden Bedienfeld (22,24,26,28,30) zugeordneten Gerätefunktion entsprechend dem ermittelten Bedienfeld (22,24,26,28,30).

2. Bedieneinheit nach Anspruch 1, **dadurch gekennzeichnet dass** die Verbindungsstege (48) aufgrund ihrer Geometrie, ihres Materials und/oder der Position ihrer Anbindung an das Trägerelement (32) und/oder an die Bedienleiste (18) steifer ausgebildet sind als die Biegestege (50) und/ oder dass die Verbindungsstege (48) kürzer sind als die Biegestege (50) und/oder eine kürzere freie Biegelänge aufweisen als die Biegestege (50), und zwar insbesondere dadurch, dass die Verbindungsstege (48) an einer ersten Anbindungsstelle von dem Trägerelement (32) und die Biegestege (50) an einer zweiten Anbindungsstelle von dem Trägerelement (32) abstehen, wobei die zweiten Anbindungsstellen von der Bedienleiste (18) weiter beabstandet sind als die ersten Anbindungsstellen.

3. Bedieneinheit nach Anspruch 2, **dadurch gekennzeichnet, dass** dann, wenn die Verbindungsstege (48) kürzer sind als die Biegestege (50), beide gleiche Geometrie und gleiches Material aufweisen.

4. Bedieneinheit nach einem der Ansprüche 1 bis 3, **dadurch gekennzeichnet, dass** das Trägerelement (32) seinerseits schwenkbar zwischen einer Ruheposition, in die das Trägerelement (32) vorgespannt ist, und mindestens einer Schwenkposition gelagert ist und dass mit der Auswerte- und Ansteuereinheit (78) mindestens ein Schwenkpositionssensor (44,46) zur Erfassung der Einnahme der Schwenkposition des Trägerelement (32) bei einer Betätigung der Bedienleiste (18) verbunden ist.

5. Bedieneinheit nach einem der Ansprüche 1 bis 4, **dadurch gekennzeichnet, dass** die Verbindungsstege (48) und die Biegestege (50) von einem gemeinsamen Quersteg (56) abstehen und dass das Trägerelement (32) einen Trägerkörper (34) mit wechselweise nebeneinander angeordneten Randaussparungen (60) und diese voneinander trennenden Vorsprungsbereichen (62), die einen zur Bedienleiste (18) weisenden Bedienleisten-Randabschnitt (58) des Trägerkörpers (34) bilden, aufweist, wobei die Biegestege (50) in den Randaussparungen (60) verlaufen sowie über den Bedienleisten-Randabschnitt (58) überstehen und die Verbindungsstege (48) in den Vorsprungsbereichen (62) des Trägerkörpers (34) an diesem fixiert sind sowie ebenfalls über den Bedienleisten-Randabschnitt (58) überstehen.

6. Bedieneinheit nach Anspruch 5, **dadurch gekennzeichnet , dass** der Quersteg (56), die Verbindungsstege (48) und die Biegestege (50) ein einstückiges, kammartiges Verbindungselement (59) des Trägerelements (32) mit der Bedienleiste (18) bilden und dass das Trägerelement (32) das Verbindungselement (59) umspritzten Kunststoff aufweist oder dass das Verbindungselement (59) auf andere Weise an dem Trägerelement (32) fixiert ist.

7. Bedieneinheit nach Anspruch 6, **dadurch gekennzeichnet, dass** das Verbindungselement (59) Metall aufweist.

8. Bedieneinheit nach einem der Ansprüche 5 bis 7, **dadurch gekennzeichnet, dass** mit dem Trägerkörper (34) mindestens eine Betätigungssensor-Trägerplatte (74,76) verbunden ist, wobei die Betätigungssensor-Trägerplatte (74,76) die Randaussparungen (60) des Trägerkörpers (34) überdeckt und in diesen Überdeckungsbereichen den Biegestegen (50) zugeordnete Bedienfeld-Betätigungssensoren (70,72) aufweist, mit denen eine Verbiegung der Biegestege (50) in lediglich einer Richtung oder in zwei entgegengesetzten Richtungen detektierbar ist.

9. Bedieneinheit nach Anspruch 8, **dadurch gekennzeichnet, dass** der Trägerkörper (34) zwischen zwei Betätigungssensor-Trägerplatten (74,76) angeordnet ist, wobei den Biegestegen (50) jeweils zwei Bedienfeld-Betätigungssensoren (70,72) zugeordnet sind, von denen der eine an der einen Trägerplatte (74) und der andere an der anderen Trägerplatte (76) angeordnet sein kann.

10. Bedieneinheit nach einem der Ansprüche 1 bis 9, **dadurch gekennzeichnet, dass** die Bedienfeld-Betätigungssensoren (70,72) und, sofern vorhanden, der Schwenkpositionssensor (44,46) kapazitiv, induktiv, ohmsch oder optisch arbeiten oder als Endschalter ausgebildet sind.

11. Bedieneinheit nach einem der Ansprüche 1 bis 10, **dadurch gekennzeichnet, dass** die Bedienleiste (18) zumindest auf ihrer Bedienfläche (20) mit einer beschichteten und somit veredelten Oberfläche versehen ist.

12. Bedieneinheit nach einem der Ansprüche 1 bis 11, **dadurch gekennzeichnet, dass** mit den Bedienfeld-Betätigungssensoren (70,72) eine Betätigung der Bedienleiste (18) sowohl bei einer oberseitigen als auch bei einer unterseitigen Anlage des Fingers einer Hand an der Bedienleiste (18) erfassbar ist.

13. Bedieneinheit nach einem der Ansprüche 1 bis 12, **dadurch gekennzeichnet, dass** das elektrische Gerät eine Fahrzeugkomponente ist.

14. Bedieneinheit nach Anspruch 13, **dadurch gekennzeichnet, dass** die Fahrzeugkomponente eine Heizungs-, Lüftungs- und/oder Klimaanlage ist.

## Claims

1. Operating unit for an electrical apparatus, the operating unit being provided with
- a housing (12) having a front wall (14),
- an operating strip (18) projecting beyond the front wall (14), the operating strip having an elongated operating surface (20) with a plurality of operating fields (22, 24, 26, 28, 30) arranged side by side,
- a support element (32) for the operating strip (18), which is arranged in the housing (12),
- wherein the operating strip (18) is connected to the support element (32) by means of connecting webs (48) which protrude in the respective areas between the operating fields (22, 24, 26, 28, 30) of the operating strip (18),
- wherein flexible webs (50), which protrude from the operating strip (18) for each operating field and are connected to the support element (32), are arranged between the connecting webs (48), namely in an elastic manner and more flexible than the connections of the operating strip (18) to the support element (32) via the connecting webs (48),
- wherein at least one operating field actuation sensor (70, 72) is arranged on the support element (32) for each flexible web (50) for the detection of a local bending of the operating strip (18), when a manual actuating force is exerted on an operating field (22, 24, 26, 28, 30) of the operating strip (18), and
- an evaluation and operating unit (78) for receiving the signals of the operating field actuation sensors (70, 72) and for determining, on the basis of said signals, the operating field (22, 24, 26, 28, 30) on which, upon manual actuation of the operating strip (18), a finger of one hand is applied, and for triggering an apparatus function that is associated with the respective operating field (22, 24, 26, 28, 30) corresponding to the determined operating field (22, 24, 26, 28, 30).

2. Operating unit of claim 1, **characterized in that** for reasons of their geometry, their material and/or the position of their connection with the support element (32) and/or the operating strip (18), the connecting webs (48) are more rigid than the flexible webs (50) and/or that the connecting webs (48) are shorter than the flexible webs (50) and/or have a shorter free bending length than the flexible webs (50), in particular due to the fact that the connecting webs (48) protrude from the support element (32) at a first connection point and the flexible webs (50) protrude from the support element (32) at a second connection point, the second connection points being spaced farther from the operating strip (18) than the first connection point.

3. Operating unit of claim 2, **characterized in that**, if the connecting webs (48) are shorter than the flexible webs (50), both have the same geometry and comprise the same material.

4. Operating unit of one of claims 1 to 3, **characterized in that** the support element (32) itself is supported to be pivotable between a rest position into which the support element (32) is prestressed and at least one pivot position, and that the evaluation and control unit (78) is connected with at least one pivot position sensor (44, 46) for detecting that the support element (32) has adopted a pivot position when the operating strip (18) is actuated.

5. Operating unit of one of claims 1 to 4, **characterized in that** the connecting webs (48) and the flexible webs (50) protrude from a common transversal web (56), and that the support element (32) has a support body (34) with alternately arranged adjacent edge recesses (60) and projection regions (62) separating the recesses from each other, which regions form an operating strip edge portion (58) of the support body (34) directed towards the operating strip (18), wherein the flexible webs (50) extend in the edge recesses (60) and protrude beyond the operating strip edge portion (58), and wherein the flexible webs (50) are fixed to the support body (34) in the projection regions (62) and also protrude beyond the operating strip edge portion (58).

6. Operating unit of claim 5, **characterized in that** the transversal web (56), the connecting webs (48) and the flexible webs (50) form an integral, comb-like connecting element (59) of the support element (32) with the operating strip (18), and that the support element (32) may comprise plastic material overmolding the connecting element (59) or that the connecting element (59) is fixed to the support element (32) in another manner.

7. Operating unit of claim 6, **characterized in that** the connecting element (59) comprises metal.

8. Operating unit of one of claims 5 to 7, **characterized in that** at least one actuation sensor support plate (74, 76) is connected with the support body (34), the actuation sensor support plate (74, 76) covering the edge recesses (60) of the support body (34) and comprising operating field actuation sensors (70, 72) in these covering regions, which sensors are assigned to the flexible webs (50), and which sensors allow the detection of a bending of the flexible webs (50) in only one direction or in two opposite directions.

9. Operating unit of claim 8, **characterized in that** the support body (34) is arranged between two actuation sensor support plates (74, 76), each flexible web (50) having two operating field actuation sensors (70, 72) assigned thereto, one of which is adapted to be arranged on the one support plate (74) and the other can be arranged on the other support plate (76).

10. Operating unit of one of claims 1 to 9, **characterized in that** the operating field actuation sensors (70, 72) and, if provided, the pivot position sensor (44, 46) function in a capacitive, inductive, ohmical or optical manner or are designed as limit switches.

11. Operating unit of one of claims 1 to 10, **characterized in that** the operating strip (18) is provided with a coated and thus finished surface at least on its operating field (20).

12. Operating unit of one of claims 1 to 11, **characterized in that** the operating field actuation sensors (70, 72) allow the detection of an actuation of the operating strip (18) both when a finger of a hand is in contact with the upper side or the lower side of the operating strip (18).

13. Operating unit of one of claims 1 to 12, **characterized in that** the electrical apparatus is a vehicle component.

14. Operating unit of claim 13, **characterized in that** the vehicle component is a heating, ventilation and/or air condition system.

## Revendications

1. Unité de commande pour un appareil électrique, avec
- un boîtier (12) qui présente une paroi avant (14),
- un bandeau de commande (18), en saillie par rapport à la paroi avant (14), qui présente une surface de commande (20) allongée dotée d'une multiplicité de panneaux de commande (22, 24, 26, 28, 30) juxtaposés,
- un élément de support (32) pour le bandeau de commande (18), disposé dans le boîtier (12),
- le bandeau de commande (18) étant raccordé à l'élément de support (32) par le biais de nervures de raccordement (48) qui dépassent du bandeau de commande (18) dans les zones respectives entre les panneaux de commande (22, 24, 26, 28, 30) du bandeau de commande (18),
- des nervures de flexion (50) qui sont disposées entre les nervures de raccordement (48) et qui dépassent du bandeau de commande (18) pour chaque champ de commande et qui sont raccordées à l'élément de support (32), et cela de façon élastique ainsi que de façon plus flexible que les raccordements du bandeau de commande (18) à l'élément de support (32) par le biais des nervures de raccordement (48),
- au moins un capteur d'actionnement de panneau de commande (70, 72) pour chaque nervure courbée (50) étant disposé sur l'élément de support (32) pour la détection d'une flexion locale du bandeau de commande (18) lors de l'exercice d'une force d'actionnement manuelle sur un panneau de commande (22, 24, 26, 28, 30) du bandeau de commande (18), et
- une unité d'analyse et de pilotage (78) pour la réception des signaux des capteurs d'actionnement de panneau de commande (70, 72) ainsi que pour la détermination, intervenant à l'aide de ces signaux, du panneau de commande (22, 24, 26, 28, 30) sur lequel est posé le doigt d'une main lors de l'actionnement manuel du bandeau de commande (18), et pour le déclenchement d'une fonction d'appareil affectée au panneau de commande (22, 24, 26, 28, 30) concerné conformément au panneau de commande (22, 24, 26, 28, 30) déterminé.

2. Unité de commande selon la revendication 1, **caractérisée en ce que**, du fait de leur géométrie, de leur matériau et/ou de la position de leur liaison avec l'élément de support (32) et/ou avec le bandeau de commande (18), les nervures de raccordement (48) sont constituées de façon plus rigide que les nervures de flexion (50) et/ou **en ce que** les nervures de raccordement (48) sont plus courtes que les nervures de flexion (50) et/ou présentent une longueur de flexion libre plus courte que les nervures de flexion (50), et à savoir en particulier **en ce que** les nervures de raccordement (48), dans un premier emplacement de liaison, dépassent de l'élément de support (32), et les nervures de flexion (50), dans un deuxième emplacement de liaison, dépassent de l'élément de support (32), les deuxièmes emplacements de liaison étant plus éloignés du bandeau de commande (18) que les premiers emplacements de liaison.

3. Unité de commande selon la revendication 2, **caractérisée en ce que**, lorsque les nervures de raccordement (48) sont plus courtes que les nervures de flexion (50), les deux présentent une géométrie identique et un matériau identique.

4. Unité de commande selon l'une des revendications 1 à 3, **caractérisée en ce que** l'élément de support (32), de son côté, est supporté de façon à pouvoir pivoter entre une position de repos dans laquelle l'élément de support (32) est prétendu et au moins une position de pivotement, et **en ce qu'**au moins un capteur de position de pivotement (44, 46) destiné à détecter l'occupation de la position de pivotement de l'élément de support (32) lors d'un actionnement du bandeau de commande (18) est raccordé à l'unité d'analyse et de pilotage (78).

5. Unité de commande selon l'une des revendications 1 à 4, **caractérisée en ce que** les nervures de raccordement (48) et les nervures de flexion (50) dépassent d'une nervure oblique (56) commune, et **en ce que** l'élément de support (32) présente un corps de support (34) avec des évidements de bord (60) juxtaposés de façon alternée et avec des zones en saillie (62) qui séparent ceux-ci les uns des autres, et qui forment un tronçon de bord de bandeau de commande (58), dirigé vers le bandeau de commande (18), du corps de support (34), les nervures de flexion (50) s'étendant dans les évidements de bord (60) et dépassant du tronçon de bord de bandeau de commande (58), et les nervures de raccordement (48) dans les zones en saillie (62) du corps de support (34) étant fixées à celui-ci et dépassant également du tronçon de bord de bandeau de commande (58).

6. Unité de commande selon la revendication 5, **caractérisée en ce que** la nervure oblique (56), les nervures de raccordement (48) et les nervures de flexion (50) forment un élément de raccordement (59), d'un seul tenant et en forme de peigne, de l'élément de support (32) avec le bandeau de commande (18), et **en ce que** l'élément de support (32) présente une matière plastique qui gaine l'élément de raccordement (59) ou **en ce que** l'élément de raccordement (59) est fixé d'une autre façon sur l'élément de support (32).

7. Unité de commande selon la revendication 6, **caractérisée en ce que** l'élément de raccordement (59) présente du métal.

8. Unité de commande selon l'une des revendications 5 à 7, **caractérisée en ce qu'**au moins une plaque de support de capteur d'actionnement (74, 76) est raccordée au corps de support (34), la plaque de support de capteur d'actionnement (74, 76) recouvrant les évidements de bord (60) du corps de support (34) et, dans ces zones de recouvrement, présentant des capteurs d'actionnement de panneau de commande (70, 72), affectés aux nervures de flexion (50), avec lesquels une flexion des nervures de flexion (50) dans une seule direction ou dans deux directions opposées peut être détectée.

9. Unité de commande selon la revendication 8, **caractérisée en ce que** le corps de support (34) est disposé entre deux plaques de support de capteur d'actionnement (74, 76), respectivement deux capteurs d'actionnement de panneau de commande (70, 72) étant affectés aux nervures de flexion (50), dont l'un peut être affecté à une plaque de support (74) et l'autre peut être affecté à l'autre plaque de support (76).

10. Unité de commande selon l'une des revendications 1 à 9, **caractérisée en ce que** les capteurs d'actionnement de panneau de commande (70, 72) et, s'il y a lieu, le capteur de position de pivotement (44, 46) fonctionnent de façon capacitive, inductive, ohmique ou optique ou sont constitués en tant qu'interrupteurs de fin de course.

11. Unité de commande selon l'une des revendications 1 à 10, **caractérisée en ce que**, au moins sur sa surface de commande (20), le bandeau de commande (18) est muni d'une surface revêtue et donc traitée.

12. Unité de commande selon l'une des revendications 1 à 11, **caractérisée en ce que**, avec les capteurs d'actionnement de panneau de commande (70, 72), un actionnement du bandeau de commande (18) peut être détecté aussi bien en cas d'appui par le haut que d'appui par le bas du doigt d'une main sur le bandeau de commande (18) .

13. Unité de commande selon l'une des revendications 1 à 12, **caractérisée en ce que** l'appareil électrique est un composant de véhicule.

14. Unité de commande selon la revendication 13, **caractérisée en ce que** le composant de véhicule est un système de chauffage, de ventilation et/ou de climatisation.
